# EUROPÄISCHE PATENTANMELDUNG

(11) **EP 0 703 303 A1**
(43) Veröffentlichungstag der Anmeldung: **27.03.1996**
(21) Anmeldenummer: 94111676.6
(22) Anmeldetag: 27.07.1994
(51) Int. Cl.: C23C 8/80, C23C 14/02, C23C 28/00, C23C 16/02

(54) **Korrosions- und verschleissfester Körper sowie Verfahren zu dessen Herstellung**

(71) Anmelder: BALZERS SA, F-68390 Sausheim (FR)
(72) Erfinder: Dingremont, N. M., F-54500 Vendoeuvre les Nancy (FR); Bergmann, E., CH-8887 Mels (CH); Collignon, Pierre, F-77500 Chelles (FR)
(74) Vertreter: Troesch Scheidegger Werner AG

(57) **Zusammenfassung**

Um einen korrosions- und verschleissfesten Körper zu schaffen, welcher, verglichen beispielsweise mit einem martensitischen, rostfreien Stahl, wie X90CrMoV18, vom Grundmaterial her betrachtet, einfacher verarbeitbar und kostengünstiger ist, wird ein Baustahl, wie beispielsweise X45NiCrMo4, oder ein Warmarbeitsstahl erst mit einer thermochemischen Vergütungsschicht, wie beispielsweise einer Nitridschicht, versehen, dann mit einer Hartstoffschicht, wie beispielsweise einer TiN-Schicht. Beispielsweise die Resultate potentiostatischer Messungen ergeben, dass der wie erwähnt beschichtete Bau- oder Warmarbeitsstahl bezüglich Korrosions- und Verschleissfestigkeit ausgezeichnete Eigenschaften aufweist.

## Beschreibung

Die vorliegende Erfindung betrifft einen korrosions- und verschleissfesten Körper nach dem Oberbegriff von Anspruch 1 sowie ein Verfahren zu dessen Herstellung nach demjenigen von Anspruch 5.

Für zahlreiche Anwendungen im Maschinen- und Vorrichtungsbau werden Komponenten benötigt, die verschleissfest sein sollten und starken korrosiven Angriffen widerstehen können. Dafür sind folgende Lösungen bekannt:

Die Komponenten werden aus einem ausreichend korrosionsfesten Material gefertigt und nachfolgend mit einer Verschleissschutzschicht versehen. Für einen hochwertigen Verschleissschutz eignen sich nur CVD-, PVD- bzw. PECVD-Verfahren. Als Grundwerkstoff der Komponenten kommen je nach Stärke des korrosiven Angriffs Sonderlegierungsstähle sowie austenitische oder martensitische rostfreie Stähle, in Frage. Solche Sonderlegierungsstähle können aber, wenn überhaupt, nur mit erheblichem Aufwand bearbeitet werden und sind deshalb nur bei im wesentlichen kostenunabhängigen Spezialanwendungen denkbar.

Komponenten aus austenitischen rostfreien Stählen sind wegen ihrer schlechten Zerspanbarkeit und wegen des relativ hohen Materialpreises teuer. Hinzu kommt, dass die mechanischen Eigenschaften dieser Werkstoffe für Komponenten, die mechanisch hoch belastet werden, wie für Maschinenelemente, im allgemeinen nicht ausreichend sind.

Die Korrosionsfestigkeit der austenitischen rostfreien stähle wäre in den meisten Fällen ausreichend.

Martensitische rostfreie Stähle hingegen verlieren ihre Korrosionsfestigkeit, wenn sie über ca. 300°C erhitzt werden. Dies wiederum schliesst den Einsatz gängiger CVD-Verfahren aus und lässt auch bei PVD- und PECVD-Verfahren nur diejenigen zu, die erst bei grossem Aufwand reproduzierbare Beschichtungen liefern. Einer der Gründe dafür, dass im allgemeinen eine Verschleissschutzschicht-Beschichtung bei Temperaturen höher als 300°C erfolgen sollte, ist die ansonsten ungenügende Haftung der Verschleissschutzschicht auf dem Grundmaterial.

Ein zweiter Weg, der zur Lösung des obgenannten Problems begangen wurde, ist die Verwendung von Doppelbeschichtungen. So wurde in der DE-A-38 29 007 für den Formenbau vorgeschlagen, erst mit einem nass-chemischen Verfahren eine Vergütungsschicht aus chemischem Nickel auf die Stahlgrundkörper aufzubringen und darnach eine PVD-Beschichtung mit einer Verschleissschutzschicht vorzusehen. Dieses Vorgehen in dieser Kombination ist nicht nur aufwendig und durch die Verwendung eines umweltschädigenden nass-chemischen Verfahrensschrittes problematisch; es ergeben sich auch bezüglich Kompatibilität der beiden Verfahren Probleme, weil die genaue Beherrschung der nass-chemisch abgeschiedenen Nickelschicht nur schwerlich möglich ist. Hierzu wird auf M. Hans, E. Bergmann, Surface and Coatings Techn. 62 (1993) S. 626, verwiesen.

Auch werden die beiden erwähnten Verfahren, nämlich nass-chemisch und PVD, üblicherweise von verschiedenen Unternehmungen durchgeführt, weil es sich dabei um völlig unterschiedliche Technologien handelt. Dies bringt bezüglich der Logistik derart zu behandelnder Körper bzw. Komponenten zusätzliche Probleme mit sich, welche sich beispielsweise in Terminverzögerungen, Transport- und Lagerproblemen widerspiegeln können.

Es ist Aufgabe der vorliegenden Erfindung, einen korrosions- und verschleissfesten Körper vorzuschlagen, der einerseits, von der Wahl des verwendeten Materials her betrachtet, kostengünstig ist, dessen Fertigung rationell vorgenommen werden kann, womit, von beiden Material- und Fertigungsseiten her betrachtet, eine massgebliche Kostenreduktion für die Bereitstellung korrosions- und verschleissfester Körper erwirkt wird.

Diese Aufgabe wird durch den korrosions- und verschleissfesten Körper eingangs genannter Art gelöst, der sich nach dem kennzeichnenden Teil von Anspruch 1 auszeichnet.

### Definitionen:

- Eine thermochemische Vergütungsschicht ist eine Schicht, welche mit mindestens einer Komponente ihrer Zusammensetzung in oberflächennahe Zonen anderer Materialien eindiffundiert.
- Als "Baustähle" werden bezeichnet die Stähle gemäss "ASM Metals Handbook", Bd. 1, 10. Ausgabe, von ASM International, Kapitel "Hardenable Carbon and Low Alloy Steels", S. 451-570.
- Als Warmarbeitsstähle werden bezeichnet Stähle gemäss AISI, Werkzeugstähle der Typen H.

Durch den erfindungsgemässen Körper, dessen Grundmaterial ein Baustahl oder ein Warmarbeitsstahl ist, ist das Körpergrundmaterial kostengünstig und ermöglicht, ebenso kostengünstigeinfach, beispielsweise eine spanabhebende Bearbeitung. Es ist erstaunlich, dass durch Versehen des Grundkörpers aus einem dieser Stähle mit einer thermochemischen Vergütungsund einer Hartstoffschicht ein ausserordentlich korrosions- und verschleissfester Körper entsteht, der entsprechend seiner formgebenden Bearbeitung für zahlreiche Anwendungen im Maschinen- und Vorrichtungsbau eingesetzt werden kann, gegebenenfalls sogar als Werkzeug für die Verarbeitung von organischem Material.

Gemäss Wortlaut von Anspruch 2 besteht die thermochemische Vergütungsschicht aus einem Borid, Karbid, Nitrokarbid, Karbonitrid, Oxinitrid, Oxikarbonitrid, Oxinitrokarbid, besteht aber in heute weitaus bevorzugter Weise aus einem Nitrid, dabei vorzugsweise mindestens im wesentlichen aus einer ε-Verbindung. Unter "ε-Verbindung" wird eine Verbindung der Zusammensetzung Fe₂N₃ verstanden.

Im weiteren wird, dem Wortlaut von Anspruch 3 folgend, um optimale Haftungsbedingungen für die Hartstoffschicht sicherzustellen, die Vergütungsschicht mit mindestens einem der Elemente C, N, B, O, S, Si versehen, dabei vorzugsweise dessen Anteil über einen Bereich einer Diffusionszone zwischen Vergütungsschicht und Hartstoffschicht im wesentlichen konstant gehalten.

Bekanntlich besteht nämlich die Gefahr, dass bei Aufbringen einer Hartstoffschicht, wie beispielsweise einer TiN-Schicht, auf eine thermochemische Vergütungsschicht mit den erwähnten Elementen in der genannten Diffusionszone eine Verarmung bezüglich des Anteils des erwähnten Elementes entsteht. Diese Verarmung beeinträchtigt das Haftungsverhalten der aufgebrachten Hartstoffschicht. Bei einem Körper nach dem erwähnten Anspruch 3 ist diese Gefahr weitestgehend behoben.

Dem Wortlaut von Anspruch 4 folgend, besteht die Hartstoffschicht aus einem Borid, Nitrid, Karbid, Karbonitrid, Nitrokarbid, Oxinitrid, Oxikarbonitrid, Oxinitrokarbid, vorzugsweise eines Metalles der Gruppe IVb oder einer Legierung mit mindestens einem dieser Metalle, besteht aber in der heute bevorzugten Form aus TiN.

Das erfindungsgemässe Verfahren zur Herstellung eines korrosions- und verschleissfesten Körpers zeichnet sich nach dem Wortlaut des kennzeichnenden Teils von Anspruch 5 aus.

Wesentlich dabei ist unter anderem, dass das mindestens zweistufige Verfahren in ein und derselben Vakuumbehandlungskammer durchgeführt wird, womit die oben erwähnten Nachteile bezuglich Logistik behoben werden.

Bevorzugte Ausführungsformen des erwähnten Verfahrens sind in den Ansprüchen 6 bis 8 spezifiziert.

Das erfindungsgemässe Verfahren weist insbesondere den Vorteil auf, weil es in derselben Vakuumbehandlungskammer durchgeführt wird, dass der Uebergang von Vergütungs- in Hartstoffschicht und damit die Haftungsverhältnisse der Hartstoffschicht optimiert werden können.

Im weiteren weist der erfindungsgemässe Körper mit der bevorzugt eingesetzten Nitridvergütungsschicht im wesentlichen kohlenstofffreie ε-Verbindungen auf, welche das Korrosionsverhalten des erfindungsgemässen Körpers wesentlich verbessern. Durch Vermeiden einer Kohlenstoff-Konzentrationserhöhung in der Vergütungsschicht, und insbesondere bei Vorsehen einer kohlenstofffreien ε-Verbindungs-Vergütungsschicht, wird eine besonders kompakte und chemisch inerte Schicht gebildet, die zu ausgezeichneter Korrosionsfestigkeit führt.

Die Erfindung wird anschliessend beispielsweise anhand von Figuren und Beispielen erläutert.

Es zeigen:
- Fig. 1: schematisch die Konfiguration einer für das erfindungsgemässe Verfahren beispielsweise eingesetzten Vakuumbehandlungsanlage;
- Fig. 2: die Anlage nach Fig. 1, betreibbar für Heizen und betrieben zum Aufbringen der Vergütungsschicht;
- Fig. 3: die Anlage nach Fig. 1, betrieben zum Aetzen;
- Fig. 4: die Anlage nach Fig. 1, betrieben zum Ionenplattieren;
- Fig. 5 und 6: je ein Schliffbild durch einen erfindungsgemässen Körper mit durch Nitrieren realisierter thermochemischer Vergütungsschicht und aufgebrachter TiN-Hartstoffschicht; Fig. 5: X45NiCrMo4; Fig. 6: X38CrMoV51 (je mit Vergrösserung 1000);
- Fig. 7: die Resultate potentiostatischer Messungen an einem Grundkörper aus dem Baustahl X45NiCrMo4 (a), des mit einer Nitridvergütungsschicht versehenen Körpers aus diesem Baustahl (b), des ausschliesslich mit einer TiN-Hartstoffschicht versehenen Körpers aus diesem Stahl (c) und des erfindungsgemäss sowohl mit einer Nitridvergütungsschicht wie auch einer TiN-Hartstoffschicht versehenen korrosions- und verschleissfesten Körpers aus diesem Stahl (d), nebst den Verläufen des rostfreien, martensitischen Stahls X90CrMoV18;
- Fig. 8: eine Darstellung analog zu derjenigen von Fig. 7 für einen Grundkörper aus dem Warmarbeitsstahl X38CrMoV51.

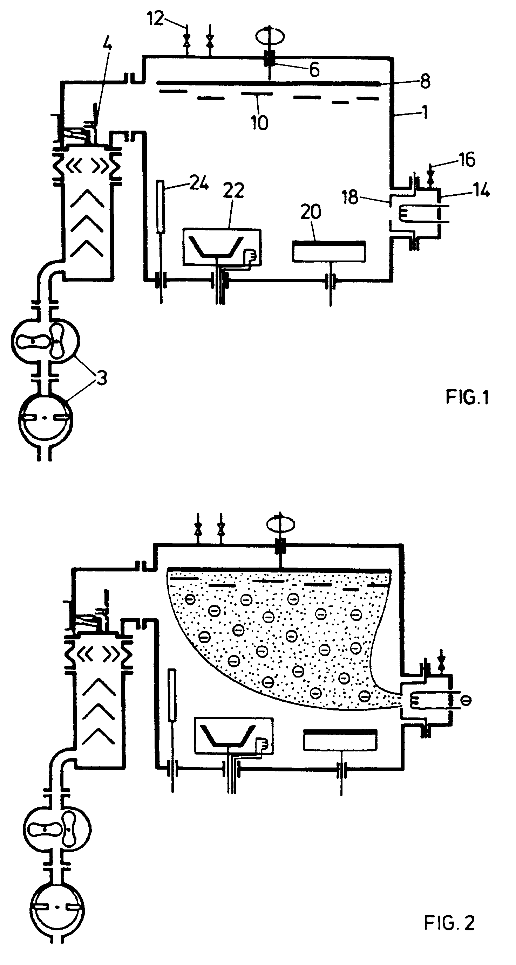

Gemäss Fig. 1 umfasst eine zur Durchführung des erfindungsgemässen Verfahrens beispielsweise eingesetzte Anlage eine Vakuumkammer 1, woran Vakuumpumpen 3 über ein steuerbares Drosselventil 4 angeschlossen sind. An einer Drehdurchführung 6 ist eine Werkstückträgerkalotte 8 vorgesehen, welche auf steuerbare Bias-Spannung gelegt werden kann. Hinter der Werkstückträgerkalotte 8 mit den schematisch eingetragenen Werkstücken 10 sind Gaseinlässe 12 vorgesehen.

An der Kammer 1 ist weiter eine Heisskathodenkammer 14 mit Gaseinlass 16 vorgesehen. Die Heisskathodenkammer 14 kommuniziert, wie schematisch dargestellt, über eine Blendenanordnung 18 mit dem Innenraum der Kammer 1. Im weiteren umfasst die Anlage in der Kammer 1 eine Planar-Magnetron-Sputterquelle 20 sowie eine Elektronenstrahl-Verdampfereinheit 22 und eine Hilfsanode 24.

Eine Anlage dieser Konfiguration ist bekannt und wird von der Anmelderin unter der Typenbezeichnung BAI640R eingesetzt und vertrieben.

Die Pumpleistung der Oeldiffusionspumpe und Wälzkolbenpumpe beträgt ca. 800 Liter in der Sekunde.

### Beispiele:

Es wurden 13mm dicke Scheibenproben ab Stangenmaterial geschnitten aus den Stählen gemäss Tabelle 1.

**Tabelle 1**

| Stahlsorte | (A) X45NiCrMo4 Baustahl | (B) X42CrNiMoV14 martensitisch rostfrei | (C) X90CrMoV18 martens. rostfrei | (D) X38CrMoV51 Warmarbeitsstahl |
|---|---|---|---|---|
| %C | 0.36 | 0.42 | 0.95-1.2 | 0.38 |
| %Ni | 3.80 | 0.50 | | |
| %Cr | 1.8 | 14.0 | 16-18 | 5.30 |
| %Mo | 0.35 | 0.15 | 0.4-0.8 | 1.30 |
| %V | | 0.1 | | 0.50 |
| %Si | 0.25 | | | 1.00 |
| %Mµ | 0.40 | | | |
| %S | <0.025 | | | |
| %P | <0.030 | | | |

### Zusammensetzung der untersuchten Stähle

Anschliessend wurden die Stahlkörper (A) und (D) einer Wärmebehandlung gemäss Tabelle 2 unterzogen. Dies erfolgte in einem bekannten Ofen.

Die Wärmebehandlung, d.h. Wärmebehandlungszeit und -temperatur, ist in Tabelle 2 zusammengestellt.

**Tabelle 2**

| Stahlsorte | | (A) | (D) |
|---|---|---|---|
| Austenisierung | °C | 875 | 1050 |
| | min | 30 | 15 |
| Tempern | °C | 540 | 550 + 595 + 550 |
| | min | 60 | 60 |

Daraufhin wurden diejenigen Körper, welche für einen Salzspraytest vorgesehen waren, geschliffen, die übrigen erst geschliffen, dann poliert.

Alle Körper wurden nun in einer bekannten Waschanlage in alkalischer Lösung, Ultraschall-unterstützt, gereinigt, dann Freon-getrocknet. Nun wurde, als Vergütungsschicht, auf die Körper nach (A) und (D) eine Nitridschicht aufgebracht, wozu die Anlage grundsätzlich gemäss Fig. 2, aber unter Einlass eines Reaktivgases, nämlich von N₂, betrieben wurde. Die Beschichtungsbedingungen für die Vergütungsschicht, im speziellen die hier betrachtete bevorzugte Nitrierungsschicht unter Einlass von N₂, sind in Tabelle 3 zusammengestellt.

**Tabelle 3**

| Stahlsorte | | (A) | (D) |
|---|---|---|---|
| Werkstücktemperatur | [°C] | 570 | 570 |
| Behandlungszeit | [h] | 2 | 2 |
| Temperatur | [°C] | 540 | 570 |
| Entladespannung | [V] | 50 | 52 |
| Entladestrom | [A] | 210 | 230 |
| Gesamtdruck | [Pa] | 0,24 | 0,4 |
| Stickstoff-Partialdruck | [Pa] | 0,12 | 0,28 |

### "Vergütungsschicht"

Anschliessend wurden die mit der Nitrierungs-Vergütungsschicht versehenen Körper aus den Stählen gemäss (A) und (D) von Tabelle 1 durch Betrieb der Anlage von Fig. 1 nach Fig. 4 durch Ionenplattieren mit einer TiN-Hartstoffschicht beschichtet.

Die für die elektrochemischen Korrosionstests vorgesehenen Körper wurden an einer konventionellen 3-Elektroden-Zelle geprüft. Das elektrische Potential der Arbeitselektrode wurde mittels einer gesättigten Calomel-Elektrode (SCE) über eine Brückenschaltung gemessen. Die Gegenelektrode war eine Graphitelektrode. Ein Computer-unterstützter Potentiostat (EG & GPAR 273 A) wurde benützt, um die Potentiale anzulegen, durchzusweepen und um das Ergebnis in Form von Potential/Stromkurven wiederzugeben.

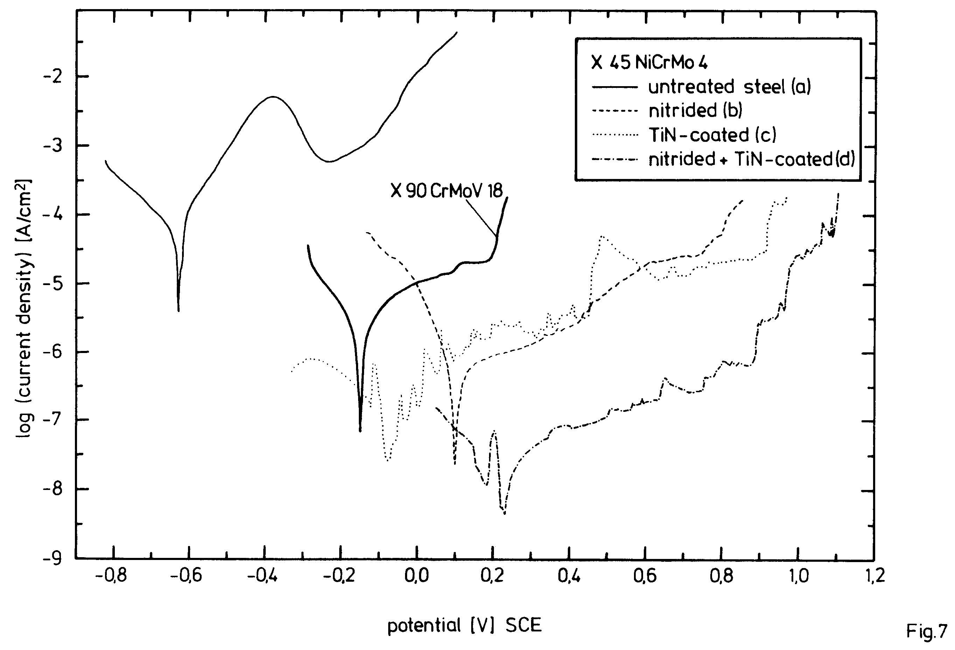

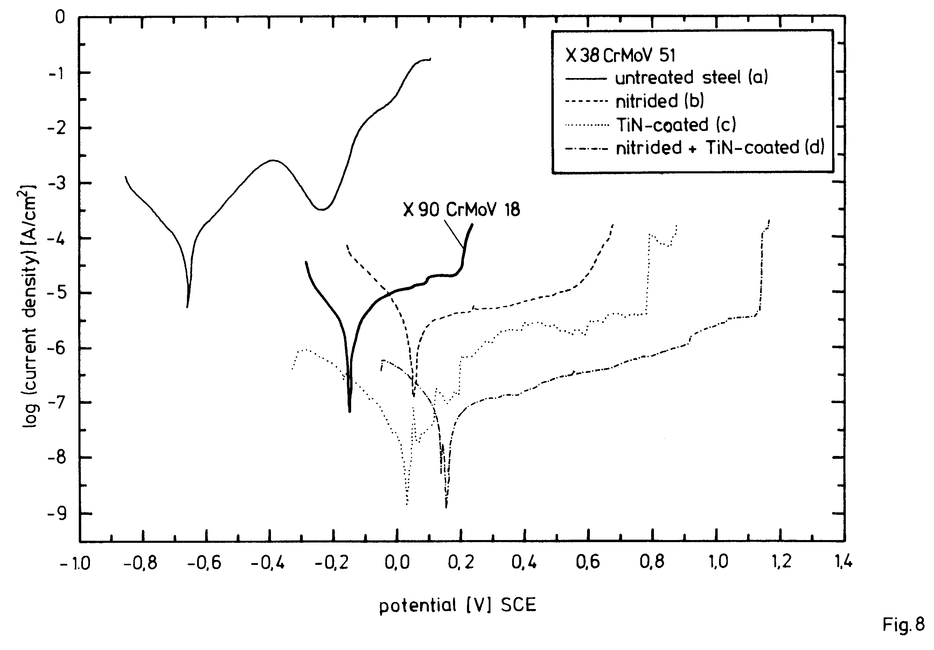

Die Resultate der potentiostatischen Messungen an unbeschichteten, nur nitrierten und nitriert- sowie hartstoffbeschichteten Körpern aus Baustahl bzw. Warmarbeitsstahl sind in den Fig. 7 bzw. 8 dargestellt.

Die potentiostatischen Messungen zeigen, dass überraschenderweise alle korrosionsrelevanten Grössen gegenüher rostfreiem Stahl signifikant verbessert werden.

Der anodische Zweig bricht bei allen Werkstoffen bei einem gewissen Potentialwert zu höheren Stromstärken aus. Werden Teile längere Zeit auf diesem elektrochemischen Potential gehalten, findet eine fortschreitende Zerstörung durch Auflösung, die meist als Lochfrass erscheint, auf. Dieses Potential wird daher Lochfrasspotential genannt. Die Aequivalenz von potentiostatischen Messungen und Korrosionsangriff im Einsatz besteht darin, dass es für die Vorgänge gleichwertig ist, ob die anodische Komponente des elektrochemischen Potentials elektrischen (potentiostat) oder chemischen (hohe Konzentration aggressiver Ionen) Ursprungs ist. Verbundwerkstoffe mit einem sehr stark anodischen Lochfrasspotential werden als edel bezeichnet. Die beiden Bilder zeigen, dass der erfindungsgemässe Verbundwerkstoff sehr viel edler ist als rostfreier Stahl. In der Praxis spielt natürlich die Kinetik eine ebenso wichtige Rolle. Es interessiert auch, wie sich der Werkstoff in weniger aggressiven Medien verhält. Dies wird elektrochemisch quantitativ als die Stromdichte bei Potentialen unterhalb des Lochfrasspotentials erfasst. Je niedriger diese Stromdichte (man beachte die logarithmische Skala) im anodischen Zweig ist, desto korrosionsfester ist ein Werkstoff. Die beiden Bilder zeigen eindrücklich nicht nur die Fortschritte gegenüher rostfreiem Stahl, sondern auch die Synergie der erfindungsgemässen Behandlung. Diese führt auch zu einem um Grössenordnungen korrosionsfesteren Werkstoff als Nitrieren oder Beschichten für sich alleine.

In Tabelle 4 sind die Resultate der Salzspraytests dargestellt.

Dabei wurde die Auswertung durch Beurteilung der einzelnen Körper nach dem Test entsprechend DIN 50021 ausgeführt. Die Bewertung '1' entspricht "keine sichtbare Korrosionsspuren" und '5' "starke Korrosion".

**Tabelle 4**

| Resultate der Salzspraytests | | | | |
|---|---|---|---|---|
| Stahlart | Baustahl X45NiCrMo4 (A) | rostfrei X42CrNiMoV 14 (B) | rostfrei X90CrMoV18 (C) | warmarb. X38CrMoV5 (D) |
| unbehandelt | 5 | 3 | 3 | 5 |
| nitriert | 2 | 3 | 3 | 3 |
| Titaniumnitridbeschichtet | 4 | 4 | 4 | 4 |
| duplexbehandelt | 1 | 2 | 2 | 2 |

Die Beurteilung wird im Lichtmikroskop vorgenommen.

Es ergibt sich ein eindeutiges Bild: Vollkommen überraschend zeigt der erfindungsgemäss behandelte Baustahl (also das billigste Grundmaterial) das beste Verhalten von allen Werkstoffen und Verbundwerkstoffen. Nicht nur übertrifft er, wie der erfindungsgemäss behandelte Warmarbeitsstahl, den unbeschichteten rostfreien Stahl, es gibt auch keine Möglichkeit, die rostfreien Stähle so zu behandeln, dass sie an diese Leistung herankommen.

Prüfkörperlose (Zylinder mit geschliffener Stirnfläche) aus den verschiedenen Stählen wurden nitriert, beschichtet oder der erfindungsgemässen Doppelbehandlung unterzogen. Danach wurden sie folgendem Verschleisstest ausgesetzt: Die Stifte wurden in einen Schleifapparat mit Siliziumkarbidschleifpapier eingespannt und mit einer Geschwindigkeit von 200 Umdrehungen/Minute abgeschliffen. Nach 12 Minuten wurde der Gewichtsverlust bestimmt. Die Resultate sind in der folgenden Tabelle zusammengestellt.

| Prüfkörper | Gewichtsverlust in mg |
|---|---|
| X5CrNi18 10 | 320 |
| X90CrMoV18 gehärtet | 62 |
| X45NiCrMo4 gehärtet | 36 |
| X38CrMoV5 gehärtet | 42 |
| X90CrMoV18 gehärtet und mit 3µm Titannitrid beschichtet | 3.2 |
| X45NiCrMo4 gehärtet und mit 3µm Titannitrid beschichtet | 4.5 |
| X38CrMoV5 gehärtet und mit 3µm Titannitrid beschichtet | 2.6 |
| X90CrMoV18 gehärtet, thermochemisch vergütet mit 10µm Verbindungsschicht | 34 |
| X45NiCrMo4 gehärtet, thermochemisch vergütet mit 10µm Verbindungsschicht vom Typ ε | 26 |
| X38CrMoV5 gehärtet, thermochemisch vergütet mit 10µm Verbindungsschicht vom Typ ε | 31 |
| X90CrMoV18 gehärtet, thermochemisch vergütet mit 10µm Verbindungsschicht und mit 3µm Titannitrid beschichtet | 1.1 |
| X45NiCrMo4 gehärtet, thermochemisch vergütet mit 10µm Verbindungsschicht vom Typ ε und mit 3µm Titannitrid beschichtet | 0.9 |
| X38CrMoV5 gehärtet, thermochemisch vergütet mit 10µm Verbindungsschicht vom Typ ε und mit 3µm Titannitrid beschichtet | 0.5 |

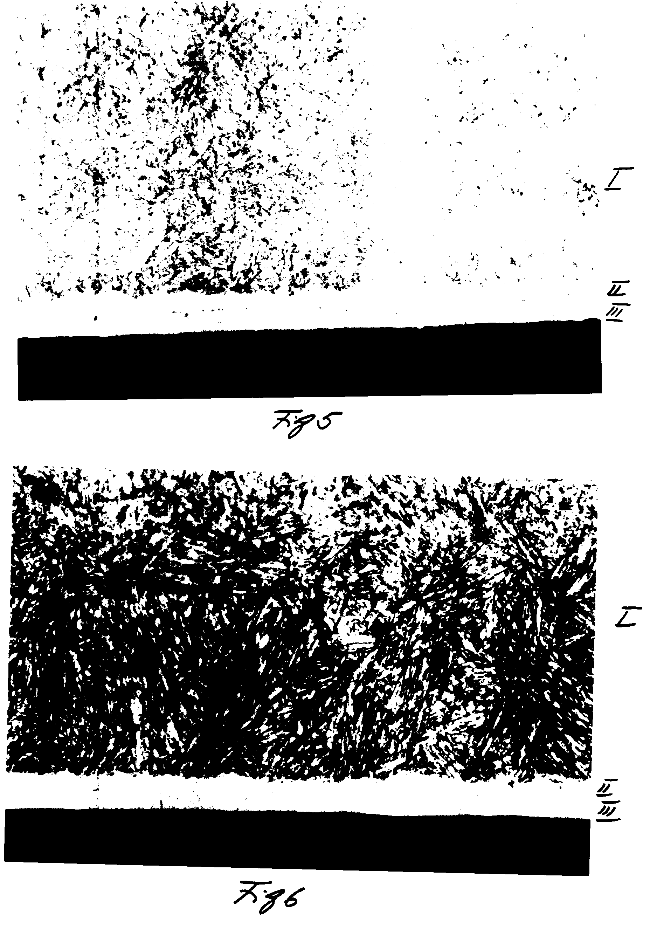

In Fig. 5 ist in tausendfacher Vergrösserung das Schliffbild des erfindungsgemäss behandelten Körpers aus X45NiCrMo4, in Fig. 6 bei gleicher Vergrösserung dasjenige eines Körpers aus dem Stahl X38CrMoV51 dargestellt. Die Zone I stellt das Stahlgefüge dar, die Zone II die thermochemische Vergütungsschicht und III die Hartstoffschicht, im vorliegenden Fall mit Titan, was aus der Gelbfärbung der Hartstoffschicht erkenntlich ist.

Im folgenden werden weitere Realisationsmöglichkeiten des vorliegenden erfindungsgemässen Verfahrens bzw. des erfindungsgemässen beschichteten Körpers dargestellt.

### 1. Erzeugung der Vergütungsschicht

Nebst durch Nitrieren, kann die Vergütungsschicht durch Borieren, Karborieren, Nitrokarborieren, Karbonitrieren, Oxinitrieren, Oxikarbonitrieren, Oxinitrokarburieren erzeugt werden, wird aber vorzugsweise durch Nitrieren des Stahlkörpers erzeugt.

### 2. Zwischenschritte zwischen Vergüten und Aufbringen der Hartstoffschicht

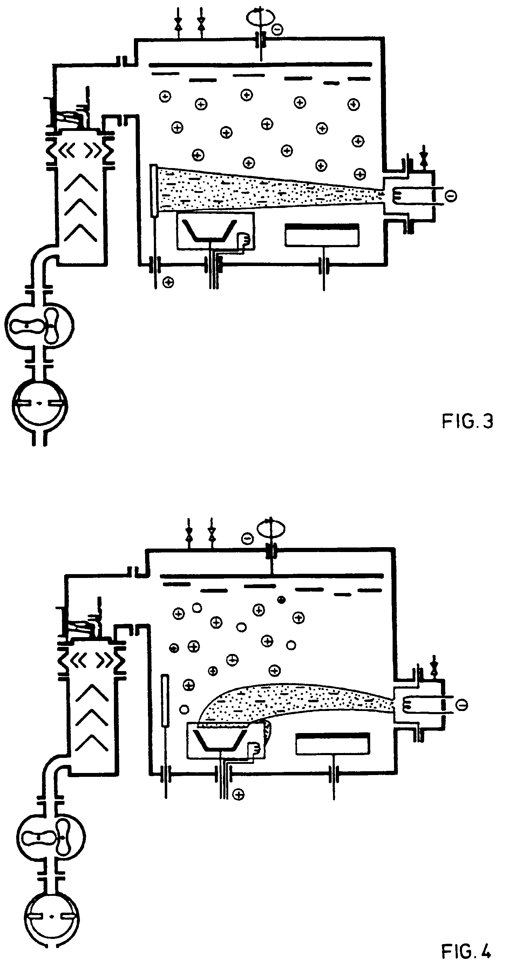

Nach Aufbringen der thermochemischen Vergütungsschicht und vor Aufbringen der Hartstoffschicht kann ein Plasmaätzprozess, ebenfalls an derselben Anlage, eingesetzt werden, wie durch Einsatz der Anlage gemäss Fig. 1 im Betrieb nach Fig. 3. Der Aetzprozess wird dabei vorteilhafterweise so geführt, dass die Vergütungsschicht nach Aufbringen der Hartstoffbeschichtung eine vorgegebene Konzentration bzw. ein vorgegebenes Konzentrationsprofil mindestens eines der Elemente C, N, B, O, S, Si aufweist, dabei insbesondere keine Verarmung bezüglich dieser "Halbmetalle" aufweist. Verarmt die Vergütungsschicht beim Aufbringen der Hartstoffschicht an den genannten "Halbmetallen", so wird dadurch die Zug- und Scherfestigkeit der aufgebrachten Hartstoffschicht verringert. Die Hartstoffschicht wird bei Vorliegen einer solchen Verarmung entweder während des Einsatzes abgeschert, oder sie platzt aufgrund der an ihr üblicherweise vorhandenen Druckeigenspannungen ab.

Indem man mithin den Aetzprozess so führt, dass eine möglicherweise bei Hartstoffbeschichtung eintretende Verarmung an diesen "Halbmetallen" kompensiert wird, wird das Entstehen der erwähnten Verarmungszonen verhindert. Der in situ- Aetzprozess wird reaktiv durchgeführt. Dadurch kann die erwähnte "Halbmetall"-Konzentration an der geätzten VergütungsschichtOberfläche beispielsweise erhöht werden, derart, dass bei nachmaliger Reduktion dieser Konzentration, nämlich bei Aufbringen der Hartstoffschicht, trotzdem keine Verarmungszonen entstehen.

### 3. Hartstoffbeschichtung

Die Hartstoffbeschichtung wird grundsätzlich mit einem reaktiven, plasmaunterstützten Verfahren aufgebracht, vorzugsweise mit einem PVD-Verfahren. Als Hartstoffschicht kann nebst der heute bevorzugten TiN-Schicht ein Borid, Nitrid, Karbid, Karbonitrid, Nitrokarbid, Oxinitrid, Oxikarbonitrid, Oxinitrokarbid, vorzugsweise eines Metalles der Gruppe IVb oder einer Legierung mit mindestens einem dieser Metalle aufgebracht werden.

Auch vor dem Aufbringen der thermochemischen Vergütungsschicht kann ein Aetzschritt, z.B. H₂-Aetzen, vorgenommen werden, um die Gleichmässigkeit der folgenden Nitrierung zu erhöhen.

## Patentansprüche

1. Korrosions- und verschleissfester Körper, dadurch gekennzeichnet, dass er aus einem Warmarbeits- oder einem Baustahl besteht, der mit einer thermochemischen Vergütungs- und einer Hartstoffschicht veredelt ist.

2. Körper nach Anspruch 1, dadurch gekennzeichnet, dass die Vergütungsschicht im wesentlichen aus einem Borid, Karbid, Nitrokarbid, Karbonitrid, Oxinitrid, Oxikarbonitrid, Oxinitrokarbid besteht, vorzugsweise aber aus einem Nitrid, dabei vorzugsweise im wesentlichen aus einer ε-Verbindung des Eisens.

3. Körper nach einem der Ansprüche 1 oder 2, dadurch gekennzeichnet, dass die Vergütungsschicht mindestens eines der Elemente C, N, B, O, S, Si umfasst und vorzugsweise dessen Anteil zur Grenzfläche zur Hartstoffschicht nicht abnimmt.

4. Körper nach einem der Ansprüche 1 bis 3, dadurch gekennzeichnet, dass die Hartstoffschicht mindestens im wesentlichen aus einem Borid, Nitrid, Karbid, Karbonitrid, Nitrokarbid, Oxinitrid, Oxikarbonitrid, Oxinitrokarbid, vorzugsweise eines Metalles der Gruppe IVb oder einer Legierung mit mindestens einem dieser Metalle besteht, vorzugsweise im wesentlichen aus TiN.

5. Verfahren zur Herstellung eines korrosions- und verschleissfesten Körpers, dadurch gekennzeichnet, dass der aus einem Bau- oder Warmarbeitsstahl bestehende Grundkörper in einer Vakuumbehandlungskammer sowohl thermochemisch vergütet wie auch hartstoffbeschichtet wird.

6. Verfahren nach Anspruch 5, dadurch gekennzeichnet, dass vor dem thermochemischen Vergüten in derselben Vakuumbehandlungskammer der Grundkörper plasmageätzt und/oder -geheizt wird.

7. Verfahren nach einem der Ansprüche 5 oder 6, dadurch gekennzeichnet, dass nach dem Aufbringen der thermochemischen Vergütungsschicht ein reaktiver, plasmaunterstützter Aetzschritt vorgenommen wird, während welchem die Zusammensetzung, insbesondere der Verlauf der Zusammensetzung, der Vergütungsschicht gesteuert wird, insbesondere der Verlauf der Konzentration eines der Elemente C, N, B, O, S, Si.

8. Verfahren nach einem der Ansprüche 5 bis 7, dadurch gekennzeichnet, dass die Hartstoffbeschichtung mittels eines PVD- oder PECVD-Verfahrens in der Vakuumbehandlungskammer erfolgt, vorzugsweise durch Ionenplattieren.
